# EUROPEAN PATENT SPECIFICATION

(11) **EP 3 491 096 B1**
(45) Date of publication and mention of the grant of the patent: **16.06.2021**
(21) Application number: 17834949.4
(22) Date of filing: 11.07.2017
(51) Int. Cl.: C09K 5/14, C08L 83/04, H01L 23/373, C08G 77/26

(54) **GEL-TYPE THERMAL INTERFACE MATERIAL**
GELARTIGES THERMISCHES ZWISCHENMATERIAL
MATÉRIAU D'INTERFACE THERMIQUE DU TYPE GEL

(30) Priority: 26.07.2016 US 201662366694 P; 05.07.2017 US 201715642092
(43) Date of publication of application: 05.06.2019
(73) Proprietor: Honeywell International Inc., Morris Plains, NJ 07950 (US)
(72) Inventor: ZHANG, Liqiang, Morris Plains, New Jersey 07950 (US); ZHANG, Kai, Morris Plains, New Jersey 07950 (US); LIU, YaQun, Morris Plains, New Jersey 07950 (US); SHEN, Ling, Morris Plains, New Jersey 07950 (US); WANG, Wei Jun, Morris Plains, New Jersey 07950 (US); KANG, Haigang, Morris Plains, New Jersey 07950 (US)
(74) Representative: Stepney, Gregory John
(86) International application number: PCT/US2017/041447
(87) International publication number: WO 2018/022288

(56) References cited:
- WO-A1-2010/104534
- WO-A1-2014/021980
- US-A1- 2007 241 303
- US-A1- 2010 105 582
- US-A1- 2015 307 743
- US-A1- 2015 307 743
- US-B2- 6 791 839

## Description

### CROSS-REFERENCE TO RELATED APPLICATIONS

This application claims priority to U.S. Provisional Patent Application Serial No. 62/366,694, filed July 26, 2016.

### FIELD OF THE INVENTION

The present disclosure relates generally to thermal interface materials, and more particularly to gel-type thermal interface materials.

### DESCRIPTION OF THE RELATED ART

Thermal interface materials (TIMs) are widely used to dissipate heat from electronic components, such as central processing units, video graphics arrays, servers, game consoles, smart phones, LED boards, and the like. Thermal interface materials are typically used to transfer excess heat from the electronic component to a heat spreader, such as a heat sink.

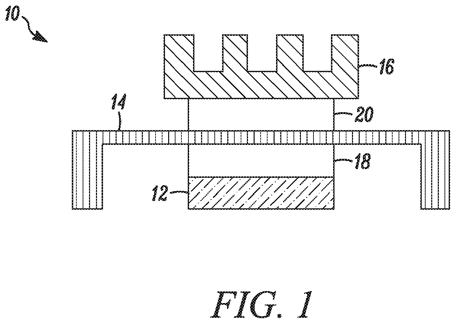

A typical electronics package structure 10 including thermal interface materials is illustrated in FIG. 1. The electronics package structure 10 illustratively includes a heat generating component, such as an electronic chip 12, and one or more heat dissipating components, such as a heat spreader 14, and a heat sink 16. Illustrative heat spreaders 14 and heat sinks comprise a metal, metal alloy, or metal-plated substrate, such as copper, copper alloy, aluminum, aluminum alloy, or nickel-plated copper. TIM materials, such as TIM 18 and TIM 20, provide a thermal connection between the heat generating component and the one or more heat dissipating components. Electronics package structure 10 includes a first TIM 18 connecting the electronic chip 12 and heat spreader 14. TIM 18 is typically referred to as a "TIM 1". Electronics package structure 10 includes a second TIM 20 connecting the heat spreader 14 and heat sink 16. TIM 20 is typically referred to as a "TIM 2". In another embodiment, electronics package structure 10 does not include a heat spreader 14, and a TIM (not shown) connects the electronic chip 12 directly to the heat sink 16. Such a TIM connecting the electronic chip 12 directly to the heat sink 16 is typically referred to as a TIM 1.5.

Traditional thermal interface materials include components such as gap pads. However, gap pads have certain disadvantages, such as inability to meet very small thickness requirements and being difficult to use in automatic production.

Other thermal interface materials include gel products. Gel products may be automatically dispensed for large scale production, and can be formed to desired shapes and thicknesses. However, typical gel products have issues with dripping and cracking in temperature cycling tests, including that the product may potentially be more likely to fail in extreme cases. US2010/105582A1 discloses a thermal interface material comprising polydimethylsiloxane, Al2O3 as thermally conductive filler, and an adhesion promoter being a amino-functional polydimethylsiloxane.

Improvements in the foregoing are desired.

### SUMMARY OF THE INVENTION

The present disclosure provides thermal interface materials that are useful in transferring heat from heat generating electronic devices, such as computer chips, to heat dissipating structures, such as heat spreaders and heat sinks.

According to an embodiment of the present disclosure, the thermal interface material includes at least one polysiloxane, at least one thermally conductive filler in an amount between 80 wt.% to 95 wt. %, and at least one adhesion promoter including both amine and alkyl functional groups, wherein the adhesion promoter has the formula: 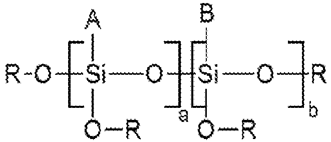 wherein:
A comprises an amine group;
B comprises an alkyl group;
each R is independently selected from methyl and ethyl; and
a and b are integers independently selected between 1 and 100, and wherein the adhesion promoter has a weight average molecular weight between 800 Daltons and 100,000 Daltons.

In an even more particular embodiment of any of the above embodiments, each amine group is selected from the group consisting of a primary amine group, a secondary amine group, and a tertiary amine group. In a more particular embodiment of any of the above embodiments, the amine group is selected from the group consisting of: 3-aminopropyl; 3-aminoisobutyl; 11-aminoundecryl; N-(2-aminoethyl)-3-aminopropyl; N-(2-aminoethyl)-3-aminoisobutyl; N-(6-aminohexyl)-aminomethyl; N-(6-aminohexyl)-3-aminopropyl; N-(2-aminoethyl)-11-aminoundecyl; and 3-(2-aminoethyl)-3-aminoisobutyl. In a more particular embodiment of any of the above embodiments, each alkyl group includes from 3 to 20 carbon atoms.

In a more particular embodiment of any of the above embodiments, the adhesion promoter has a weight average molecular weight from 800 Dalton to 3000 Dalton.

In a more particular embodiment of any of the above embodiments, the adhesion promoter comprises from 0.1 wt.% to 5 wt.% of the thermal interface material, based on the total weight of the thermal interface material.

In a more particular embodiment of any of the above embodiments, the polysiloxane comprises from 2 wt.% to 20 wt.% of the thermal interface material, based on the total weight of the thermal interface material.

In a more particular embodiment of any of the above embodiments, the thermal interface material includes a silane coupling agent. In an even more particular embodiment, the silane coupling agent is an alkyltrialkoxysilane, such as hexadecyltrimethoxysilane.

In a more particular embodiment of any of the above embodiments, the silane coupling agent comprises from 0.1 wt.% to 5 wt.% of the thermal interface material, based on the total weight of the thermal interface material.

In a more particular embodiment of any of the above embodiments, the thermally conductive filler is selected from aluminum, copper, silver, zinc, nickel, tin, indium, lead, carbon, graphite, carbon nanotubes, carbon fibers, graphenes, silicon nitride, alumina, aluminum nitride, boron nitride, zinc oxide, and tin oxide. In a more particular embodiment of any of the above embodiments,the thermally conductive filler includes a first thermally conductive filler and a second thermally conductive filler, wherein the first thermally conductive filer is a metal and the second thermally conductive filler is a metal oxide. In an even more particular embodiment, the first thermally conductive filler has a particle size greater than 1 micron and the second thermally conductive filler has a particle size less than 1 micron. In a still more particular embodiment, a ratio of the first thermally conductive filler to the second thermally conductive filler is from 1.5:1 to 3:1.

The thermally conductive filler comprises from 80 wt.% to 95 wt.% of the thermal interface material, based on the total weight of the thermal interface material.

According to an embodiment of the present disclosure, an electronic components includes a heat sink, an electronic chip, and a thermal interface material having a first surface layer and a second surface layer, the thermal interface material positioned between the heat sink and electronic chip, the thermal interface material including: at least one silicone elastomer, at least one silane coupling agent, at least one thermally conductive filler, and at least one adhesion promoter including both amine and alkyl functional groups. In some embodiments, the thermal interface material is according to any of the above embodiments. In a first more particular embodiment, the first surface layer is in contact with a surface of the electronic chip and the second surface layer is in contact with the heat sink. In a second more particular embodiment, the electronic component further comprises a heat spreader positioned between the heat sink and the electronic chip, wherein the first surface layer is in contact with a surface of the electronic chip and the second surface layer is in contact with the heat spreader. In a third more particular embodiment, the electronic component further comprises a heat spreader positioned between the heat sink and the electronic chip, wherein the first surface layer is in contact with a surface of the heat spreader and the second surface layer is in contact with the heat sink.

### BRIEF DESCRIPTION OF THE DRAWINGS

The above-mentioned and other features and advantages of this disclosure, and the manner of attaining them, will become more apparent and the invention itself will be better understood by reference to the following description of embodiments of the invention taken in conjunction with the accompanying drawings, wherein:
FIG. 1 schematically illustrates a typical electronics package structure;
FIG. 2A is related to the Examples and shows the sample formed from Example 1 before the temperature cycling test;
FIG. 2B is related to the Examples and shows the sample formed from the comparative example before the temperature cycling test;
FIG. 3A is related to the Examples and shows the sample formed from Example 1 after the temperature cycling test;
FIG. 3B is related to the Examples and shows the sample formed from the comparative example after the temperature cycling test
FIG. 4A is related to the Examples and shows the sample formed from Example 2 after the temperature cycling test;
FIG. 4B is related to the Examples and shows the sample formed from Example 3 after the temperature cycling test;
FIG. 4C is related to the Examples and shows the sample formed from Example 4 after the temperature cycling test;
FIG. 4D is related to the Examples and shows the sample formed from Example 5 after the temperature cycling test; and
FIG. 5 is related to the Examples and shows the thermal impedance for Examples 2 and 5 before and after the HAST test.

Corresponding reference characters indicate corresponding parts throughout the several views. The exemplifications set out herein illustrate exemplary embodiments of the invention and such exemplifications are not to be construed as limiting the scope of the invention in any manner.

### DETAILED DESCRIPTION

### A. Thermal Interface Material

The present invention relates to thermal interface materials (TIMs) useful in transferring heat away from electronic components. In one exemplary embodiment, the TIM comprises at least one polysiloxane, at least one thermally conductive filler, and at least one adhesion promoter including both amine and alkyl functional groups.

In some embodiments, the TIM may optionally include one or more of the following components: a silane coupling agent, an organic plasticizer, a surfactant, and a flux agent.

### 1. Polysiloxane

The TIM includes one or more polysiloxanes. The polysiloxane includes one or more crosslinkable groups, such as vinyl, hydride, hydroxyl and acrylate functional groups, that are crosslinked by the catalyst. In one embodiment, the one or more polysiloxanes include a silicone oil. In one embodiment, the one or more polysiloxanes include a first silicone oil and a second silicone oil, where the first silicone oil is a vinyl functional silicone oil and the second silicone oil is a hydride functional silicone oil. The polysiloxane wets the thermally conductive filler and forms a dispensable fluid for the TIM.

Exemplary silicone oils may include a vinyl silicone oil having a general formula as shown below:

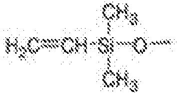

An exemplary vinyl silicone oil may also include a small amount of platinum catalyst.

Vinyl functional silicone oils include an organo-silicone component with Si-CH=CH₂ groups. Exemplary vinyl functional silicone oils include vinyl-terminated silicone oils and vinyl-grafted silicone oils in which the Si-CH=CH₂ group is grafted onto the polymer chain, and combinations thereof.

Exemplary vinyl-terminated silicone oils include vinyl terminated polydimethylsiloxane, such as DMS-V05, DMS-V21, DMS-V22, DMS-V25, DMS-V25R, DMS-V35, DMS-V35R, DMS-V51, and DMS-V52, each available from Gelest, Inc.

Exemplary vinyl-grafted silicone oils include vinylmethylsiloxane-dimethylsiloxane copolymers, such as trimethylsiloxyl terminated silicone oils, silanol terminated silicone oils, and vinyl terminated silicone oils. Exemplary trimethylsiloxyl terminated silicone oils include VDT-127, VDT-431, and VDT-731; exemplary silanol terminated silicone oils include VDS-1013; and exemplary vinyl terminated silicone oils include VDV-0131; each available from Gelest, Inc.

In one exemplary embodiment, the vinyl-grafted silicone oil is a vinylmethylsiloxane terpolymers, including a vinylmethylsiloxane-octylmethylsiloxane-dimethylsiloxane terpolymer such as VAT-4326, or a vinylmethylsiloxane-phenylmethylsiloxane-dimethylsiloxane terpolymer such as VPT-1323. In some exemplary embodiment, the vinyl-grafted silicone oil is a vinylmethoxysiloxane homopolymer such as VMM-010, or a vinylethoxysiloxane-propylethoxysiloxane copolymer such as VPE-005. VAT-4326, VPT-1323, VMM-010, and VPE-005 are each available from Gelest, Inc.,

In one exemplary embodiment, the vinyl-functional silicone oil comprises a vinyl T resin or a vinyl Q resin. A vinyl T resin is a vinyl silsesquioxane having three (tri-substituted) oxygen substituting all or some of the silicon atoms in the polymer. Exemplary T resins include poly(phenyl-vinylsilsesquixane) such as SST-3PV1, available from Gelest, Inc. A vinyl Q resin has four (tetra-substituted) oxygen substituting all or some of the silicon atoms in the polymer. Exemplary Q resins include VQM-135, VQM-146, available from Gelest, Inc. One type of vinyl Q resin is an activated cure specialty silicone rubber having the following base polymer structure:

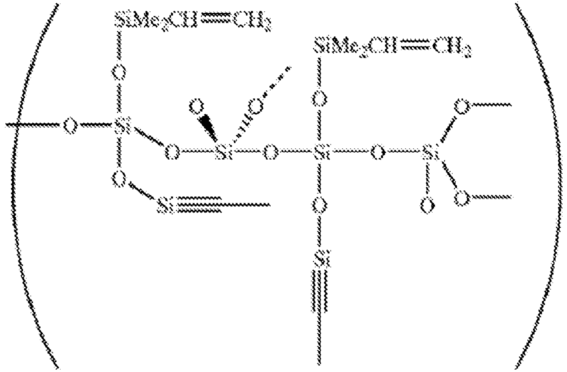

Exemplary Q resins include VQM-135, VQM-146, available from Gelest, Inc. In one exemplary embodiment, the polysiloxane is vinyl functional oil, such as RH-Vi303, RH-Vi301 from RUNHE, such as Andril® VS 200, Andril® VS 1000 from AB Specialty Silicones.

Another exemplary silicone oil may include a hydrosilicone oil having a general formula as shown below:

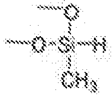

In one exemplary embodiment, the polysiloxane comprises a hydride functional silicone oil having an organo-silicone component and Si-H groups. Exemplary hydride functional silicone oils include hydride-terminated silicone oils and hydride-grafted silicone oils in which the Si-H group is grafted onto the polymer chain, and combinations thereof.

In one exemplary embodiment, the hydride-terminated silicone oil is a hydride terminated polydimethylsiloxane such as DMS-H05, DMS-H21, DMS-H25, DMS-H31, or DMS-H41, each available from Gelest, Inc. In one exemplary embodiment, the hydride-terminated silicone oil is a methylhydrosiloxane-dimethylsiloxane copolymer, such as a trimethylsiloxyl terminated or hydride terminated. Exemplary trimethylsiloxyl terminated copolymers include HMS-013, HMS-031, HMS-064, HMS-071, HMS-082, HMS-151, HMS-301, HMS-501; exemplary hydride terminated copolymers include HMS-H271; each of which is available from Gelest, Inc. In one exemplary embodiment, the hydride-grafted silicone oil is polymethylhydrosiloxane with trimethylsiloxyl terminated, such as HMS-991, HMS-992, HMS-993, each available from Gelest, Inc.

In one exemplary embodiment, the hydride-grafted silicone oil is polyethylhydrosiloxane with triethylsiloxyl terminated, such as HES-992, available from Gelest, Inc. In one exemplary embodiment, the hydride-grafted silicone oil is methylhydrosiloxane-octylmethylsiloxane copolymer, such as HAM-301 available from Gelest, Inc.

In one exemplary embodiment, the hydride functional oil is a Q resin or T resin, Exemplary T resins include SST-3MH1.1, exemplary Q resins include HQM-105 and HQM-107, each available from Gelest, Inc.

In one exemplary embodiment, the polysiloxane is a hydride functional oil, such as Andri® XL-10, Andri® XL-12 available from AB Specialty Silicones, such as RH-DH04, and RH-H503 available from RUNHE, such as KE-1012-B, KE-1031-B, KE-109E-B, KE-1051J-B, KE-1800T-B, KE1204B, KE1218B available from Shin-Etsu, such as SILBIONE® RT Gel 4725 SLD B available from Bluestar, such as SilGel® 612 B, ELASTOSIL® LR 3153B, ELASTOSIL® LR 3003B, ELASTOSIL® LR 3005B, SEMICOSIL® 961B, SEMICOSIL® 927B, SEMICOSIL® 205B, SEMICOSIL® 9212B, SILPURAN® 2440 available from Wacker, such as Silopren® LSR 2010B available from Momentive, such as XIAMETER® RBL-9200 B, XIAMETER® RBL-2004 B, XIAMETER® RBL-9050 B, XIAMETER® RBL-1552 B, Silastic® FL 30-9201 B, Silastic® 9202 B, Silastic® 9204 B, Silastic® 9206 B, SYLGARD® 184B, Dow corning® QP-1 B, Dow Corning® C6 B, Dow Corning® CV9204 B available from Dow Corning.

In one exemplary embodiment, the polysiloxane includes a silicone rubber such as the KE series products available from Shin-Etsu, such as SILBIONE® available from Bluestar, such as ELASTOSIL®, SilGel®, SILPURAN® and SEMICOSIL® available from Wacker, such as Silopren® available from Momentive, such as Dow Corning®, Silastic®, XIAMETER®, Syl-off® and SYLGARD® available from Dow Corning, such as Andril® available from AB specialty Silicones. Other polysiloxanes are available from Wacker, Shin-etsu, Dowcoring, Momentive, Bluestar, RUNHE, AB Specialty Silicones and Gelest.

The TIM may comprise the one or more polysiloxanes in an amount as little as 1wt.%, 2 wt.%, 4.5 wt.%, 4.75 wt.%, 5 wt. %, 6 wt. %, 7 wt. %, 8 wt. %, as great as 9 wt.%, 10 wt.%, 20 wt.%, 25 wt.%, 50 wt.%, or greater, or within any range defined between any two of the foregoing values, based on the total weight of the TIM, such as 1 wt.% to 50 wt.%, 1 wt.% to 20 wt.%, 2 wt.% to 10 wt.%, or 4.5 wt.% to 9 wt.%.

In one exemplary embodiment, the TIM includes a first polysiloxane as a first silicone oil in the amount of 2.0 wt.% and a second siloxane as a second silicone oil in the amount of 4.0 wt.%. In another exemplary embodiment, the TIM includes a first polysiloxane as a first silicone oil in the amount of 3.35 wt.% and a second siloxane as a second silicone oil in the amount of 6.7 wt.%.

Exemplary low molecular weight silicone oils may have a dynamic viscosity as little as 500 cPs, 600 cPs, 700 cPs, as great as 800 cPs, 900 cPs, 1,000 cPs, or within any range defined between any two of the foregoing values as measured according to ASTM D445. In one exemplary embodiment, the low molecular weight silicone oil has a dynamic viscosity of 750 cPs.

### 2. Catalyst

The TIM further includes one or more catalyst for catalyzing the addition reaction. Exemplary catalysts comprise platinum containing materials and rhodium containing materials. Exemplary platinum containing catalysts may have the general formula shown below:

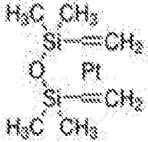

Exemplary platinum contain catalysts include: such as Platinum cyclovinylmethylsiloxane complex(Ashby Karstedt Catalyst), Platinum carbonyl cyclovinylmethylsiloxane complex(Ossko catalyst), Platinum divinyltetramethyldisiloxane dimethyl fumarate complex, Platinum divinyltetramethyldisiloxane dimethyl maleate complex and the like. Exemplary of Platinum carbonyl cyclovinylmethylsiloxane complexes include SIP6829.2, exemplary of Platinum divinyltetramethyldisiloxane complex include SIP6830.3 and SIP6831.2, exemplary of platinum cyclovinylmethylsiloxane complex include SIP6833.2, all available from Gelest, Inc.

Exemplary rhodium containing materials include Tris(dibutylsulfide)Rhodium trichloride with product code INRH078, available from Gelest, Inc.

Without wishing to be held to any particular theory it is believed that the platinum catalyst reacts with a vinyl silicone oil and a hydrosilicone oil as shown below.

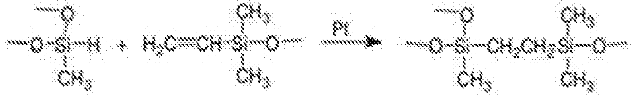

The TIM may comprise the one or more catalyst in an amount as little as 5ppm, 10ppm, 15ppm, 20ppm, as great as 25ppm, 30ppm, 40ppm, 50ppm, 100ppm, 200ppm, 500ppm, 1000ppm, or within any range defined between any two of the foregoing values, based on the total weight of the silicone oil, such as 10ppm to 30ppm, 20ppm to 100ppm, or 5ppm to 500ppm.

In one exemplary embodiment, the catalyst is provided as a mixture with one or more of the silicone oils. In one exemplary embodiment, the catalyst is combined to a vinyl functional silicone oil, such as KE-1012-A, KE-1031-A, KE-109E-A, KE-1051J-A, KE-1800T-A, KE1204A, KE1218A available from Shin-Etsu, such as SILBIONE® RT Gel 4725 SLD A available from Bluestar, such as SilGel® 612 A, ELASTOSIL® LR 3153A, ELASTOSIL® LR 3003A, ELASTOSIL® LR 3005A, SEMICOSIL® 961A, SEMICOSIL® 927A, SEMICOSIL® 205A, SEMICOSIL® 9212A, SILPURAN® 2440 available from Wacker, such as Silopren® LSR 2010A available from Momentive, such as XIAMETER® RBL-9200 A, XIAMETER® RBL-2004 A, XIAMETER® RBL-9050 A, XIAMETER® RBL-1552 A, Silastic® FL 30-9201 A, Silastic® 9202 A, Silastic® 9204 A, Silastic® 9206 A, SYLGARD® 184A, Dow Corning® QP-1 A, Dow corning® C6 A, Dow Corning® CV9204 A available from Dow Corning. In one exemplary embodiment, the catalyst is combined to vinyl and hydride functional silicone oils, such as KE-1056, KE-1151, KE-1820, KE-1825, KE-1830, KE-1831, KE-1833, KE-1842, KE-1884, KE-1885, KE-1886, FE-57, FE-61 available from Shin-Etsu, such as Syl-off® 7395, Syl-off® 7610, Syl-off® 7817, Syl-off® 7612, Syl-off® 7780 available from Dow Corning.

The TIM may comprise a catalyst in an amount as little as 0.01 wt%, 0.1 wt.%, 0.2 wt.%, as great as 0.3 wt.%, 0.4 wt.%, 0.5 wt.%, or within any range defined between any two of the foregoing values, based on the total weight of the TIM. In one exemplary embodiment, the TIM includes a catalyst in the amount of 0.04 wt.%. In another exemplary embodiment, the TIM includes a catalyst in the amount of 0.4 wt.%.

### 3. Thermally conductive filler

The TIM includes one or more thermally conductive fillers. Exemplary thermally conductive fillers include metals, alloys, nonmetals, metal oxides and ceramics, and combinations thereof. The metals include, but are not limited to, aluminum, copper, silver, zinc, nickel, tin, indium, and lead. The nonmetal include, but are not limited to, carbon, graphite, carbon nanotubes, carbon fibers, graphenes, boron nitride and silicon nitride. The metal oxide or ceramics include but not limited to alumina (aluminum oxide), aluminum nitride, boron nitride, zinc oxide, and tin oxide.

The TIM may comprise the one or more thermally conductive fillers in an amount as little as 80 wt.%, as great as 80 wt.%, 85 wt.%, 90 wt.%, 95 wt.%, or within any range defined between any two of the foregoing values, based on the total weight of the TIM, such as 85 wt.% to 95 wt.%.

Exemplary thermally conductive fillers may have an average particle size of as little as 0.1 microns, 1 micron, 10 microns, as great as 50 microns, 75 microns, 100 microns or within any range defined between any two of the foregoing values.

In one exemplary embodiment, the TIM may include a first thermally conductive filler and a second thermally conductive filler, wherein the first thermally conductive filer is a plurality of metal particles having have a particle size greater than 1 micron and the second thermally conductive filler is a plurality of nonmetal particles, such as metal oxide particles, having a particle size less than 1 micron. In a more particular embodiment, a ratio of the first thermally conductive filler to the second thermally conductive filler may be as little as 1:5, 1:4, 1:3, 1:2, as great as 1:1, 1.5:1, 2:1, 3:1, 4:1, 5:1, or within any range defined between any two of the foregoing values, such as 1:5 to 5:1 1:1 to 3:1, or 1.5:1 to 3:1.

Exemplary thermal conductive fillers include alumina and zinc oxide.

### 4. Adhesion promoter

The TIM includes one or more adhesion promoters including both amine and alkyl functional groups. An exemplary adhesion promoter has the following formula (I): 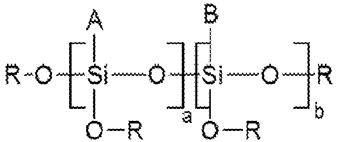 wherein R is independently selected from hydrogen, alkyl with carbon atoms 1 to 6; wherein A comprises an amine group and B comprises an alkyl group; wherein a, b is independently integer 1 to 100.

In some exemplary embodiments, R includes methyl and ethyl.

In some exemplary amine group A includes primary amine, secondary amine, tertiary amine or the combination thereof. In some exemplary alkyl group B includes alkyl group include the alkyl with carbon atom 1 to 40.

In some exemplary embodiments, the amine group A comprise primary amine with general formula CₙHₓNH₂, wherein n and x are integers independently selected between 1 and 30. Exemplary primary amine includes aminomethyl group CH₂NH₂, 2-aminoethyl group CH₂CH₂NH₂, 3-aminopropyl group CH₂CH₂CH₂NH₂, 3-aminoisobutyl group CH₂CH(CH₃)CH₂NH₂, 4-aminobutyl group CH₂CH₂CH₂CH₂NH₂, 4-amino-3,3-dimethylbutyl group CH₂CH₂C(CH₃)₂CH₂NH₂, aminophenyl group C₆H₄NH₂, 11-aminoundecryl group CH₂(CH₂)₉CH₂NH₂,

In some exemplary embodiments, the amine group A comprise secondary amine with general formula CₙHₓNHCₘH_{y}, wherein m, n, x and y are integers independently selected between 1 and 30. Exemplary secondary amine includes ethylamino group NHCH₂CH₃, n-butyl-3-aminopropyl group CH₂CH₂CH₂NHCH₂CH₂CH₂CH₃, t-butyl-3-aminopropyl group CH₂CH₂CH₂NHC(CH₃)₃, N-cyclohexyl-3-aminopropyl group CH₂CH₂CH₂NHC₆H₁₁, N-ethyl-3-aminoisobutyl group CH₂CH(CH₃)CH₂NHCH₂CH₃, anilino group NHC₆H₅,

In some exemplary embodiments, the amine group A comprise tertiary amine with general formula CₙHₓN(CₘH_{y})(CₗH_{z}), wherein I, m, n, x, y, and z are integers independently selected between 1 and 30, wherein the group CₘH_{y} and CₗH_{z} are both bonded to N atom. Exemplary tertiary amine includes dimethylamino group N(CH₃)₂, N,N-dimethyl-3-aminopropyl group CH₂CH₂CH₂N(CH₃)₂, N,N-diethyl aminomethyl group CH₂N(CH₂CH₃)₂, N,N-diethyl-3-aminopropyl group CH₂CH₂CH₂N(CH₂CH₃)₂.

In some exemplary embodiments, the amine group A comprises a combination of primary amines, secondary amines, and /or tertiary amines. Exemplary amine combinations includes N-(2-aminoethyl)-3-aminopropyl group CH₂CH₂CH₂NHCH₂CH₂NH₂, N-(2-aminoethyl)-aminomethylphenethyl group CH₂CH₂C₆H₄CH₂NHCH₂CH₂NH₂, N-(2-aminoethyl)-3-aminoisobutyl group CH₂CH(CH₃)CH₂NHCH₂CH₂NH₂, N-(6-aminohexyl)-aminomethyl group CH₂NHCH₂CH₂CH₂CH₂CH₂CH₂NH₂, N-(6-aminohexyl)-3-aminopropyl group CH₂CH₂CH₂NHCH₂CH₂CH₂CH₂CH₂CH₂NH₂, N-(2-aminoethyl)-11-aminoundecyl group CH₂(CH₂)₉CH₂NHCH₂CH₂NH₂, 3-(2-aminoethyl)-3-aminoisobutyl group CH₂CH(CH₃)CH(NH₂)CH₂CH₂NH₂,

In some other exemplary embodiments, the amine group A comprises a cyclic-base amine. Exemplary cyclic-based amine groups A include the following:
- 2-(2-pyridyl) ethyl group 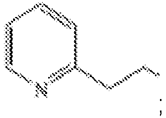
- 3-(1H-pyrrole) propyl group 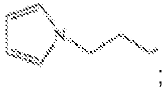 and
- (9-carbazole) ethyl group

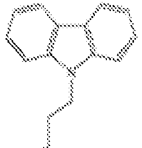

In some exemplary embodiments, the amine group A includes from 1 to 20 carbon atoms.

Exemplary adhesion promomters include Dynasylan® functional silanes available from Evonic. In some exemplary embodiments, the adhesion promoter is Dynasylan® functional silane 1146 wherein the polymer is block type and polymer includes amine and alkyl functional units.

The adhesion promoter has a weight average molecular weight as little as 800 Dalton, 900 Dalton, as great as 1000 Dalton, 2000 Dalton, 3000 Dalton, 5000 Dalton, 10,000 Dalton, 50,000 Dalton, 100,000 Dalton, or within any range defined between any two of the foregoing values, such as 800 Dalton to 100,000 Dalton, 800 Dalton to 3000 Dalton, or 1000 Dalton to 3000 Dalton.

In some exemplary embodiments, the TIM may comprise the one or more adhesion promoters in an amount as little as 0.1 wt.%, 0.2 wt.%, 0.25 wt.%, 0.3 wt.%, 0.4 wt.%, 0.5 wt.%, as great as 0.6 wt.%, 0.7 wt.%, 0.75 wt.%, 1 wt.%, 1.5 wt.%, 2 wt.%, 5 wt.%, or within any range defined between any two of the foregoing values, based on the total weight of the TIM, such as 0.1 wt.% to 5 wt.%, 0.1 wt.% to 1 wt.%, or 0.25 wt.% to 0.75 wt.%.

Without wishing to be held to any particular theory, it is believed that the relatively higher molecular weight of the adhesion promoter reduces or eliminates evaporation of the adhesion promoter from the formulation during production or usage. Compared with a typical silane including only an amino-functional group, an adhesion promoter including both amine and alkyl functional groups is believed to provide better comparability with polysiloxane due to the inclusion of alkyl side chains on the polysiloxane. The adhesion promoter is also believed to provide hydrophobic properties to avoid moisture uptake during the production of the formulation or in usage. It is further believed that an adhesion promoter including both amine and alkyl functional groups increase the adhesion between the polysiloxane and filler, as well as adhesion between the TIM and the substrate.

### 5. Optional components

In some embodiments, the TIM may optionally include one or more of the following components: a silane coupling agent, an organic plasticizer, a surfactant, and a flux agent.

In some exemplary embodiments, the TIM comprises one or more coupling agents. Exemplary coupling agents include silane coupling agents with general formula Y-(CH₂)ₙ-Si-X₃, wherein Y is organofunctional group, X is hydrolysable group. Organofunctional group Y includes alkyl, glycidoxy, acryloxyl, methylacryloxyl, amine. Hydrolysable group X includes alkyloxy, acetoxy. In some exemplary embodiments, the silane coupling agent includes alkyltrialkoxysilanes. Exemplary alkytrialkoxy silane comprise decyltrimethoxylsilane, undecyltrimethoxylsilane, hexadecyltrimethoxysilane, octadecyltrimethoxysilane. In one exemplary embodiment, the TIM includes hexadecyltrimethoxysilane as the coupling agent as shown in the formula below.

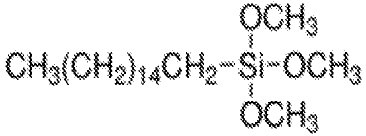

Exemplary coupling agents interact with exemplary fillers as shown in the example reaction below. Alumina is the representative filler used in the reaction below; however, other alternative fillers may be used. As shown, the coupling agent is added to water and undergoes hydrolysis to remove an ethoxide group. The products then undergo a modification reaction where water is removed and the coupling agent and alumina are bonded together.

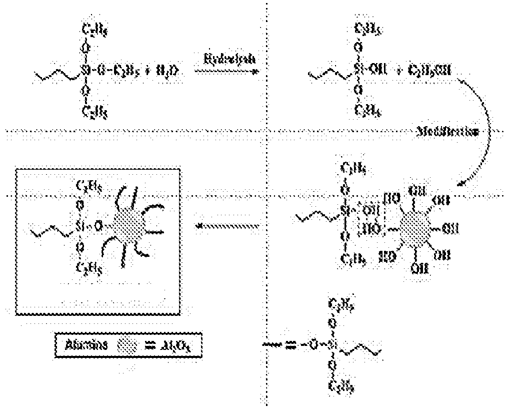

In some exemplary embodiments, the TIM may comprise the one or more coupling agents in an amount as little as 0.1 wt.%, 0.25 wt.%, 0.5 wt.%, 0.67 wt.%, 0.75 wt.%, as great as 1 wt.%, 1.5 wt.%, 2 wt.%, 5 wt.%, 10 wt.%, or within any range defined between any two of the foregoing values, based on the total weight of the TIM, such as 0.1 wt.% to 10 wt.%, 0.1 wt.% to 1 wt.%, or 0.25 wt.% to 0.67 wt.%. In one exemplary embodiment, the TIM includes a coupling agent in the amount of 0.4 wt.%.

In some exemplary embodiments, the TIM comprises one or more organic plasticizers. Exemplary organic plasticizers include phthalate-based plasticizers such as Bis(2-ethylhexyl) phthalate (DEHP) , Di-n-butyl phthalate (DnBP, DBP), Dioctyl phthalate (DOP or DnOP), Diethyl phthalate (DEP), Diisobutyl phthalate (DIBP), Diisodecyl phthalate (DIDP), Diisononyl phthalate (DINP), and Butyl benzyl phthalate (BBzP).

In some exemplary embodiments, the TIM may comprise the one or more organic plasticizers in an amount as little as 0.01%, 0.1 wt.%, 0.25 wt.%, 0.5 wt.%, 0.67 wt.%, 0.75 wt.%, as great as 1 wt.%, 1.5 wt.%, 2 wt.%, 5 wt.%, 10 wt.%, or within any range defined between any two of the foregoing values, based on the total weight of the TIM, such as 0.01 wt.% to 10 wt.%, 0.1 wt.% to 1 wt.%, or 0.25 wt.% to 0.67 wt.%.

In some exemplary embodiments, the TIM comprises one or more surfactants. Exemplary surfactants include silicone based surface additives, such as the BYK surfactants available from BYK Chemie GmbH, including BYK-307, BYK-306, and BYK-222.

In some exemplary embodiments, the TIM may comprise the one or more surfactants in an amount as little as 0.01%, 0.1 wt.%, 0.25 wt.%, 0.5 wt.%, 0.67 wt.%, 0.75 wt.%, as great as 1 wt.%, 1.5 wt.%, 2 wt.%, 5 wt.%, 10 wt.%, or within any range defined between any two of the foregoing values, based on the total weight of the TIM, such as 0.1 wt.% to 10 wt.%, 0.1 wt.% to 1 wt.%, or 0.25 wt.% to 0.67 wt.%.

In some exemplary embodiments, the TIM comprises one or more flux agents. Exemplary flux agents include fumed silica.

In some exemplary embodiments, the TIM may comprise the one or more flux agents in an amount as little as 0.1 wt.%, 0.25 wt.%, 0.5 wt.%, 0.67 wt.%, 0.75 wt.%, as great as 1 wt.%, 1.5 wt.%, 2 wt.%, 5 wt.%, 10 wt.%, or within any range defined between any two of the foregoing values, based on the total weight of the TIM, such as 0.1 wt.% to 10 wt.%, 0.1 wt.% to 1 wt.%, or 0.25 wt.% to 0.67 wt.%.

In addition, the TIM may comprise one or more addition inhibitors for inhibiting or limiting crosslinking of the silicone oils. The addition inhibitors can include at least one alkynyl compound, and optionally, the addition inhibitor may further include a multi-vinyl functional polysiloxane.

Exemplary addition inhibitors can include acetylenic alcohols such as 1-ethynyl-1-cyclohexanol, 2-methyl-3-butyn-2-ol, 2-phenyl-3-butyn-2-ol, 2-ethynyl-isopropanol, 2-ethynyl-butane-2-ol, and 3,5-dimethyl-1-hexyn-3-ol; silylated acetylenic alcohols such as trimethyl (3,5-dimethyl-1-hexyn-3-oxy)silane, dimethyl-bis-(3-methyl-1-butyn-oxy)silane, methylvinylbis(3-methyl-1 -butyn-3-oxy)silane, and ((1,1-dimethyl-2-propynyl)oxy)trimethylsilane; unsaturated carboxylic esters such as diallyl maleate, dimethyl maleate, diethyl fumarate, diallyl fumarate, and bis-2-methoxy-1-methylethylmaleate, mono-octylmaleate, mono-isooctylmaleate, mono-allyl maleate, mono-methyl maleate, mono-ethyl fumarate, mono-allyl fumarate, 2-methoxy-1-methylethylmaleate; fumarate/alcohol mixtures, such as mixtures where the alcohol is selected from benzyl alcohol or 1-octanol and ethenyl cyclohexyl-1-ol; conjugated ene-ynes such as 2-isobutyl-1-butene-3-yne, 3,5-dimethyl-3-hexene-1-yne, 3-methyl-3-pentene-1-yne, 3-methyl-3-hexene-1-yne, 1-ethynylcyclohexene, 3-ethyl-3-butene-1-yne, and 3-phenyl-3-butene-1-yne; vinylcyclosiloxanes such as I,3,5,7-tetramethyl-1,3,5,7-tetravinylcyclotetrasiloxane, and mixtures of conjugated ene-yne and vinylcyclosiloxane. In one exemplary embodiment, the addition inhibitor is selected from 2-methyl-3-butyn-2-ol or 3-methyl-1-pentyn-3-ol.

In some exemplary embodiments, the addition inhibitor may further include a multi-vinyl functional polysiloxane. An exemplary multi-vinyl functional polysiloxane is a vinyl terminated polydimethylsiloxane in ethynyl cyclohexanol, such as Pt Inhibitor 88 available from Wacker Chemie AG. Without wishing to be held to any particular theory it is believed that the platinum catalyst forms a complex with ethynyl cyclohexanol and vinyl terminated polydimethylsiloxane as shown below.

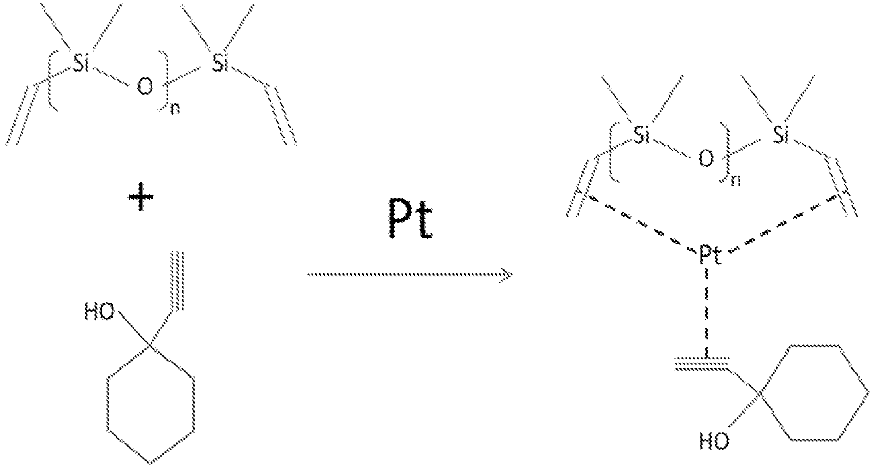

The formation of the complex is believed to decrease the catalyst activity in room temperature, and thus maintaining the dispensability and wettability of the TIM. At the higher temperatures of the curing step, the Pt is released from the complex and help the hydrosilylation of vinyl functional silicone oil and hydride functional silicone oil, provides greater control over the "crosslinking".

In some exemplary embodiments, the TIM may comprise the one or more addition inhibitors in an amount as little as 0.01 wt.%, 0.02 wt.%, 0.05 wt.%, 0.1 wt.%, 0.15 wt.%, as great as 0.2 wt.%, 0.25 wt.%, 0.3 wt.%, 0.5 wt.%, 1 wt.%, 3 wt.%, 5 wt.%, or within any range defined between any two of the foregoing values, based on the total weight of the TIM, such as 0.01 wt.% to 1 wt.%, 0.01 wt.% to 0.5 wt.%, or 0.05 wt.% to 0.2 wt.%. In one exemplary embodiment, the TIM includes an addition inhibitor in the amount of 0.1 wt.%. In another exemplary embodiment, the TIM includes an addition inhibitor in the amount of 0.13 wt.%.

Without wishing to be held to any particular theory, it is believed that, in the absence of an addition inhibitor, the vinyl functional silicone oil reacts with the hydride functional silicone oil very quickly based on the addition hydrosilylation mechanism to form a solid phase that cannot be automatically dispensed by typical methods.

In one exemplary embodiment, the addition inhibitor is combined to functional silicone oils.

### 6. Exemplary formulations of the Thermal Interface Material

In a first non-limiting illustrative embodiment, the TIM includes about 2 wt.% to about 20 wt.% polysiloxane, about 0.1 wt.% to about 5 wt.% coupling agent, about 50 wt.% to about 95 wt.% thermally conductive filler, and about 0.1 wt.% to about 5 wt.% adhesion promoter.

### 7. Exemplary properties of the Thermal Interface Material

In some exemplary embodiments, a thermal interface material as described above has excellent resistance to highly-accelerated stress testing (HAST). HAST testing is typically understood to relate to the resistance of the thermal interface material to humidity and temperature on the thermal performance of the thermal interface material. An exemplary HAST test standard is JESD22-A110-B. In one particular embodiment, the thermal interface material shows no change in thermal properties, such as thermal impedance, after being conditioned at 130°C and 85% relative humidity for 96 hours.

In some exemplary embodiments, a thermal interface material as described above has excellent resistance to temperature cycling. Temperature cycling is typically understood to relate to the resistance of the thermal interface material to extremes of high and low temperatures, as well as its ability to withstand cyclical thermal stresses. An exemplary temperature cycling test standard is JESD22-A104-B. In one particular embodiment, the thermal interface material shows no dripping when placed between a glass an exemplary copper heat sink at in a vertically oriented 1.6 mm gap and subjected to 10000 thermal cycles between - 55°C and +125°C over one week. In other embodiments, the thermal interface material shows little to no cracking following the temperature cycling test.

In some exemplary embodiments, a thermal interface material as described above has the thermal conductivity at least 1 W/m.K. An exemplary thermal conductivity test method standard is ASTM D5470. In one exemplary amendment, a thermal interface material as described above has the thermal conductivity of about 4 W/m.K. In another exemplary embodiment, a thermal interface material as described above has the thermal conductivity of about 2 W/m.K.

In some exemplary embodiments, a thermal interface material as described above has the viscosity in the range of 10 Pa.s to 100,000 Pa.s, or more particularly in the range of 100 Pa.s to 10,000 Pa.s at room temperature. An exemplary viscosity test method standard is DIN 53018. In one particular embodiment, the viscosity is tested by Brookfield Rheometer with shear rate 2 s⁻¹.

As applied, a thermal interface material can have a varied thickness as measured by a micrometer. In some exemplary embodiments, a thermal interface material as described above has a thickness of as little as 0.05 mm, 0.5 mm, 1 mm, as great as 3 mm, 5 mm, 7 mm, 10 mm or within any range defined between any two of the foregoing values, such as from 0.05 mm to 5 mm.

In some exemplary embodiments, a thermal interface material as described above is compressible at a given temperature when cured. In one exemplary embodiment, the thermal interface material is compressible by at least 10% at a temperature of about 25°C.

In some exemplary embodiments, a thermal interface material as described above has the dispense rate in the range of 1 g/min to 1000 g/min, or more particularly in the range of 10 g/min to 100 g/min. In one particular embodiment, the dispense rate is tested under 0.6 MPa pressure with a 10 ml syringe having a 0.1 inch diameter dispense header opening.

### B. Methods of forming a Thermal Interface Material

In some exemplary embodiments, the TIM is prepared by combining the individual components in a heated mixer and blending the composition together. The blended composition may then be applied directly to the substrate without baking.

### C. Applications utilizing the Thermal Interface Material

Referring again to FIG. 1, in some exemplary embodiments, the thermal interface material is positioned as a TIM 1 between an electronic component 12 and a heat spreader 14, as indicated by TIM 18. In some exemplary embodiments, the thermal interface material is positioned as a TIM 2 between a heat spreader 14 and a heat sink 16, as indicated by TIM 20. In some exemplary embodiments, the thermal interface material is positioned as a TIM 1.5 (not shown) between an electronic component 12 and a heat sink 16.

### EXAMPLES

### Example 1

A thermal interface material was prepared according to the formulation provided in Table 1.

**Table 1: Formulations (wt.%) for Example 1**

| **Component** | **Wt.%** |
|---|---|
| Polysiloxane | 9 |
| Silane coupling agent | 0.5 |
| Thermal conductive filler A | 60 |
| Thermal conductive filler B | 30 |
| Adhesion promoter | 0.5 |

The polysiloxane was liquid silicone. The silane coupling agent was hexadecyltrimethoxysilane. Thermal conductive filler A was aluminum particles having a particle diameter between 1 and 10 microns. Thermal conductive filler B was zinc oxide particles having a particle diameter less than 1 micron. The adhesion promoter was Dynasylan® functional silane 1146 available from Evonic.

To prepare the formulation of Example 1, the polysiloxane, silane coupling agent, and adhesion promoter were combined and blended with a speed mixer. The thermally conductive fillers were then added, and the mixture was blended again.

A GEL 30 Thermally Conductive Dispensable Gel from Parker Chomerics was obtained for use a comparative example. GEL 30 includes a partially cross-linked silicone rubber and alumina.

The formulation of Example 1 and the comparative example were each sandwiched between a glass and an exemplary heat sink in a vertically oriented 1.6 mm gap and subjected to 10000 thermal cycles between -55°C and +125°C over one week

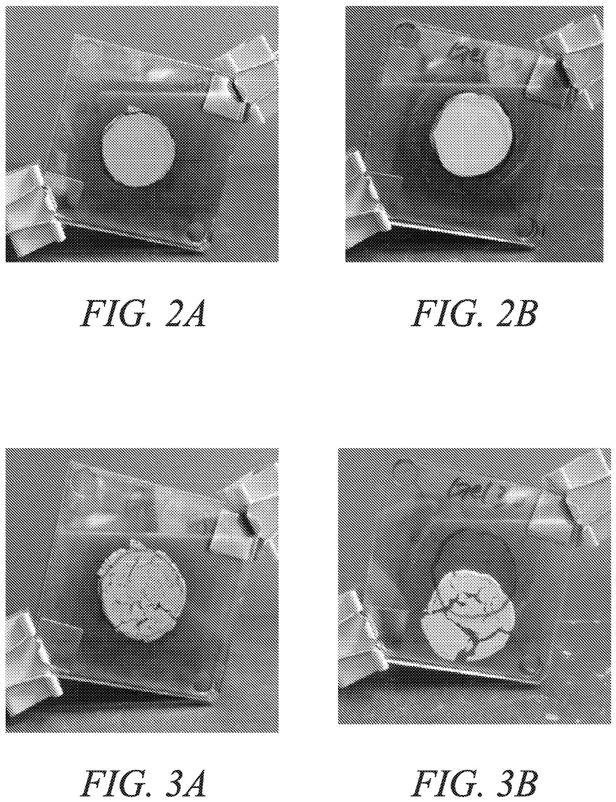

Figure 2A shows the sample formed from Example 1 before the temperature cycling test and Figure 2B shows the sample formed from the GEL 30 comparative example before the temperature cycling test. Figure 3A shows the sample formed from Example 1 after the temperature cycling test and Figure 3B shows the sample formed from the GEL 30 comparative example after the temperature cycling test.

As shown in Figure 3A, the sample formed from Example 1 showed no dripping, as indicated by the sample maintaining its original vertical position between the glass and substrate during the test. In contrast, the sample formed from the comparative example showed significant dripping as indicated by the movement downward between Figures 2B and 3B.

In addition, Figure 3A showed limited cracking of the sample formed from Example 1 due to the temperature cycling test. In contrast, Figure 3B showed significantly more cracking in the comparative example.

### Examples 2-5

Thermal interface materials were prepared according to the formulation provided in Table 2.

**Table 2: Formulations (wt.%) for Examples 1-5**

| **Component** | **Ex. 2 (Wt.%)** | **Ex. 3 (Wt.%)** | **Ex. 4 (Wt.%)** | **Ex. 5 (Wt.%)** |
|---|---|---|---|---|
| Polysiloxane | 9 | 9 | 9 | 9 |
| Silane coupling agent | 0.5 | 0.5 | 0.5 | 0.5 |
| Thermal conductive filler | 90 | 90 | 90 | 90 |
| Adhesion promoter | 0.5 | 0.5 | 0.5 | 0.5 |

The polysiloxane was liquid silicone rubber. The silane coupling agent was hexadecyltrimethoxysilane. The thermal conductive filler was aluminum oxide particles a particle diameter between 0.1 and 150 microns.

For Example 2, the adhesion promoter was Dynasylan® functional silane 1146 available from Evonic, having the general formula: 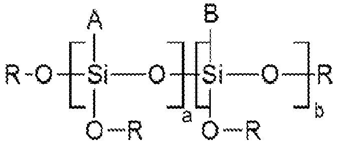 where A is organo-amino, B is alkyl, and R is Si-O-CH₃.

For Example 3, the adhesion promoter was Dynasylan® functional silane 6598 available from Evonic, having the general formula: 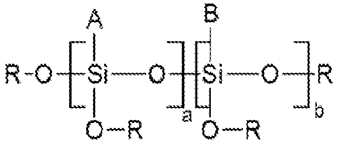 where A is vinyl, B is alkyl, and R is Si-O-CH₃.

For Example 4 (not according to the invention), the adhesion promoter was an epoxy-functional silane, having the general formula:

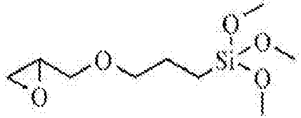

For Example 5 (not according to the invention), the adhesion promoter was a methacryl-functional silane having the general formula:

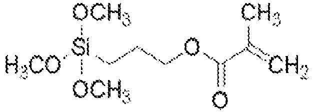

To prepare the formulation of each example, the polysiloxane, silane coupling agent, and adhesion promoter were combined and blended with a speed mixer. The thermally conductive fillers were then added, and the mixture was blended again.

Each example was sandwiched between a glass and an exemplary copper heat sink in a vertically oriented 1.6 mm gap and subjected to 10000 thermal cycles between -55°C and +125°C over one week.

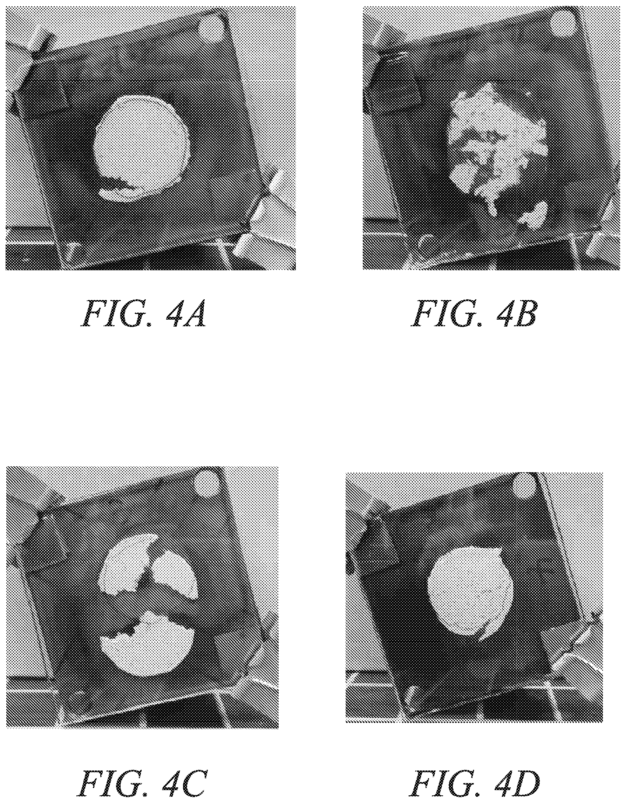

Figure 4A shows the sample formed from Example 2 after the temperature cycling test. Figure 4B shows the sample formed from Example 3 after the temperature cycling test. Figure 4C shows the sample formed from Example 4 after the temperature cycling test. Figure 4D shows the sample formed from Example 5 after the temperature cycling test.

As shown in Figures 4A and 4D, the samples formed from Examples 2 and 5 showed no dripping, as indicated by the sample maintaining its original vertical position between the glass and substrate during the test. In addition, the samples formed from Examples 2 and 5 showed little to no cracking following the temperature. In contrast, as shown in Figures 4B and 4C, the samples formed Examples 3 and 5 showed significant dripping as indicated by the movement away from the center of the sample, as well as significant cracking compared to Examples 2 and 5.

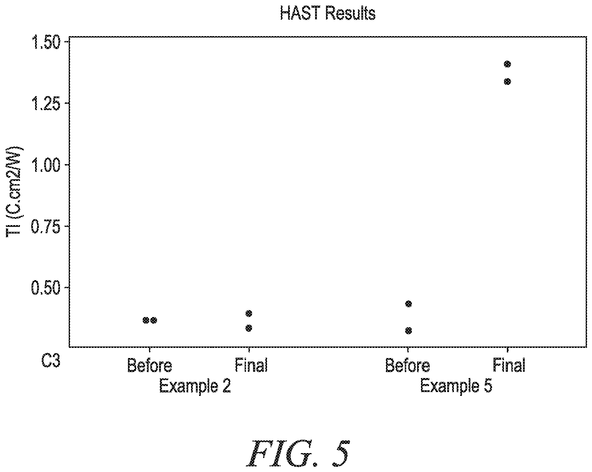

Referring next to Figure 5, the thermal impedance (TI) of two samples each formed from Examples 2 and 5 were measured before and after HAST conditions at 130°C and 85% relative humidity for 96 hours. As shown in Figure 5, Example 2 had no significant change in thermal impedance in the HAST test, while Example 5 had a significant increase in thermal impedance.

## Claims

1. A thermal interface material comprising:
at least one polysiloxane;
at least one thermally conductive filler in an amount between 80 wt.% to 95 wt.%; and
at least one adhesion promoter including both amine and alkyl functional groups;
wherein the adhesion promoter has the formula: 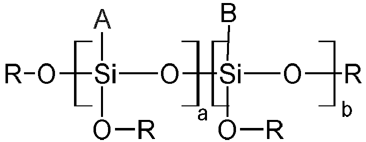 wherein:
A comprises an amine group;
B comprises an alkyl group;
each R is independently selected from methyl and ethyl; and
a and b are integers independently selected between 1 and 100; and wherein the adhesion promoter was a weight average molecular weight between 800 Daltons and 100,000 Daltons.

2. The thermal interface material of claim 1, wherein the adhesion promoter is a functional polysiloxane.

3. The thermal interface material of claim 1, wherein the thermally conductive filler includes a first thermally conductive filler and a second thermally conductive filler, wherein the first thermally conductive filer is a metal and the second thermally conductive filler is a metal oxide.

4. The thermal interface material of claim 1, wherein the thermal interface material comprises:
from 2 wt.% to 20 wt.% of the polysiloxane;
from 0.1 wt.% to 5 wt.% of a silane coupling agent;
from 80 wt.% to 95 wt.% of the thermally conductive filler; and
from 0.1 wt.% to 5 wt.% of the adhesion promoter.

5. An electronic component comprising:
a heat sink;
an electronic chip;
a thermal interface material having a first surface layer and a second surface layer, the thermal interface material positioned between the heat sink and electronic chip, the thermal interface material including:
at least one polysiloxane;
at least one silane coupling agent
at least one thermally conductive filler in an amount between 80 wt.% to 95 wt.%; and
at least one adhesion promoter including both amine and alkyl functional groups;
wherein the adhesion promoter has the formula: 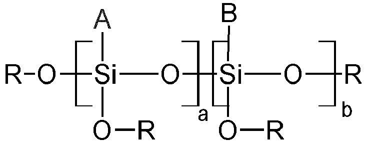 wherein:
A comprises an amine group;
B comprises an alkyl group;
each R is independently selected from methyl and ethyl; and
a and b are integers independently selected between 1 and 100; and wherein the adhesion promoter was a weight average molecular weight between 800 Daltons and 100,000 Daltons.

6. The electronic component of claim 5, wherein the first surface layer is in contact with a surface of the electronic chip and the second surface layer is in contact with the heat sink.

7. The electronic component of claim 5, wherein the electronic component further comprises a heat spreader positioned between the heat sink and the electronic chip, wherein the first surface layer is in contact with a surface of the electronic chip and the second surface layer is in contact with the heat spreader.

8. The electronic component of claim 5, the electronic component further comprises a heat spreader positioned between the heat sink and the electronic chip, wherein the first surface layer is in contact with a surface of the heat spreader and the second surface layer is in contact with the heat sink.

## Patentansprüche

1. Thermisches Zwischenmaterial, umfassend:
mindestens ein Polysiloxan;
mindestens einen wärmeleitfähigen Füllstoff in einer Menge zwischen 80 Gew.-% und 95 Gew.-%; und
mindestens einen Haftvermittler, der sowohl funktionelle Amin- als auch Alkylgruppen einschließt;
wobei der Haftvermittler die Formel hat: 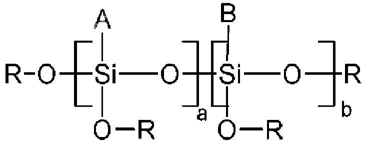 wobei:
A eine Amingruppe umfasst;
B eine Alkylgruppe umfasst;
jedes R unabhängig aus Methyl und Ethyl ausgewählt ist; und
a und b ganze Zahlen sind, die unabhängig voneinander zwischen 1 und 100 ausgewählt sind; und wobei der Haftvermittler ein Gewichtsmittel des Molekulargewichts zwischen 800 Dalton und 100.000 Dalton war.

2. Thermisches Zwischenmaterial nach Anspruch 1, wobei der Haftvermittler ein funktionelles Polysiloxan ist.

3. Thermisches Zwischenmaterial nach Anspruch 1, wobei der wärmeleitfähige Füllstoff einen ersten wärmeleitfähigen Füllstoff und einen zweiten wärmeleitfähigen Füllstoff umfasst, wobei der erste wärmeleitfähige Füllstoff ein Metall ist, und der zweite wärmeleitfähige Füllstoff ein Metalloxid ist.

4. Thermisches Zwischenmaterial nach Anspruch 1, wobei das thermische Zwischenmaterial umfasst:
von 2 Gew.-% bis 20 Gew.-% des Polysiloxans;
von 0,1 Gew.-% bis 5 Gew.-% eines Silankopplungsmittels;
von 80 Gew.-% bis 95 Gew.-% des wärmeleitfähigen Füllstoffs; und
von 0,1 Gew.-% bis 5 Gew.-% des Haftvermittlers.

5. Elektronische Komponente, umfassend:
einen Kühlkörper;
einen elektronischen Chip;
ein thermisches Zwischenmaterial mit einer ersten Oberflächenschicht und einer zweiten Oberflächenschicht, wobei das thermische Zwischenmaterial zwischen dem Kühlkörper und dem elektronischen Chip positioniert ist, wobei das thermische Zwischenmaterial umfasst:
mindestens ein Polysiloxan;
mindestens ein Silankopplungsmittel
mindestens einen wärmeleitfähigen Füllstoff in einer Menge zwischen 80 Gew.-% und 95 Gew.-%; und
mindestens einen Haftvermittler, der sowohl funktionelle Amin- als auch Alkylgruppen einschließt;
wobei der Haftvermittler die Formel hat: 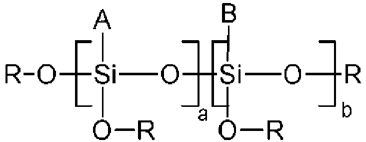 wobei:
A eine Amingruppe umfasst;
B eine Alkylgruppe umfasst;
jedes R unabhängig aus Methyl und Ethyl ausgewählt ist; und
a und b ganze Zahlen sind, die unabhängig voneinander zwischen 1 und 100 ausgewählt sind; und wobei der Haftvermittler ein Gewichtsmittel des Molekulargewichts zwischen 800 Dalton und 100.000 Dalton war.

6. Elektronische Komponente nach Anspruch 5, wobei die erste Oberflächenschicht mit einer Oberfläche des elektronischen Chips in Kontakt steht und die zweite Oberflächenschicht mit dem Kühlkörper in Kontakt steht.

7. Elektronische Komponente nach Anspruch 5, wobei die elektronische Komponente ferner einen Wärmeverteiler umfasst, der zwischen dem Kühlkörper und dem elektronischen Chip positioniert ist, wobei die erste Oberflächenschicht mit einer Oberfläche des elektronischen Chips in Kontakt steht und die zweite Oberflächenschicht mit dem Wärmeverteiler in Kontakt steht.

8. Elektronische Komponente nach Anspruch 5, die elektronische Komponente umfasst ferner einen Wärmeverteiler, der zwischen dem Kühlkörper und dem elektronischen Chip positioniert ist, wobei die erste Oberflächenschicht mit einer Oberfläche des elektronischen Chips in Kontakt steht und die zweite Oberflächenschicht mit dem Wärmeverteiler in Kontakt steht.

## Revendications

1. Matériau d'interface thermique comprenant :
au moins un polysiloxane ;
au moins une charge thermoconductrice en quantité comprise entre 80 % en poids et 95 % en poids ; et
au moins un promoteur d'adhérence comprenant à la fois des groupes fonctionnels amine et alkyle ;
le promoteur d'adhérence étant représenté par la formule : 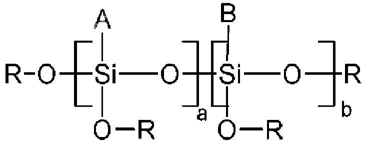 dans laquelle :
A comprend un groupe aminé ;
B comprend un groupe alkyle ;
chaque R est indépendamment choisi parmi méthyle et éthyle ; et
a et b sont des nombres entiers choisis indépendamment entre 1 et 100 ; et le promoteur d'adhérence ayant une masse moléculaire moyenne en poids comprise entre 800 daltons et 100 000 daltons.

2. Matériau d'interface thermique selon la revendication 1, dans lequel le promoteur d'adhérence est un polysiloxane fonctionnel.

3. Matériau d'interface thermique selon la revendication 1, dans lequel la charge thermoconductrice comprend une première charge thermoconductrice et une seconde charge thermoconductrice, la première charge thermoconductrice étant un métal et la seconde charge thermoconductrice étant un oxyde métallique.

4. Matériau d'interface thermique selon la revendication 1, le matériau d'interface thermique comprenant :
de 2 % en poids à 20 % en poids du polysiloxane ;
de 0,1 % en poids à 5 % en poids d'un agent de couplage à base de silane ;
de 80 % en poids à 95 % en poids de la charge thermoconductrice ; et
de 0,1 % en poids à 5 % en poids du promoteur d'adhérence.

5. Composant électronique comprenant :
un puits thermique ;
une puce électronique ;
un matériau d'interface thermique comportant une première couche de surface et une seconde couche de surface, le matériau d'interface thermique étant positionné entre le puits thermique et la puce électronique, et le matériau d'interface thermique comprenant :
au moins un polysiloxane ;
au moins un agent de couplage de silane ;
au moins une charge thermoconductrice en quantité comprise entre 80 % en poids et 95 % en poids ; et
au moins un promoteur d'adhérence comprenant à la fois des groupes fonctionnels amine et alkyle ;
le promoteur d'adhérence étant représenté par la formule : 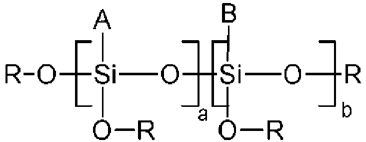 dans laquelle :
A comprend un groupe aminé ;
B comprend un groupe alkyle ;
chaque R est indépendamment choisi parmi méthyle et éthyle ; et
a et b sont des nombres entiers choisis indépendamment entre 1 et 100 ; et le promoteur d'adhérence ayant une masse moléculaire moyenne en poids comprise entre 800 daltons et 100 000 daltons.

6. Composant électronique selon la revendication 5, dans lequel la première couche de surface est en contact avec une surface de la puce électronique et la seconde couche de surface est en contact avec le puits thermique.

7. Composant électronique selon la revendication 5, le composant électronique comprenant en outre un dissipateur thermique positionné entre le puits thermique et la puce électronique, la première couche de surface étant en contact avec une surface de la puce électronique et la seconde couche de surface étant en contact avec le dissipateur thermique.

8. Composant électronique selon la revendication 5, le composant électronique comprenant en outre un dissipateur thermique positionné entre le puits thermique et la puce électronique, la première couche de surface étant en contact avec une surface du dissipateur thermique et la seconde couche de surface étant en contact avec le puits thermique.
